(19)

**Europäisches Patentamt**
**European Patent Office**
**Office européen des brevets**

(11) **EP 4 312 299 A2**

(12) # EUROPEAN PATENT APPLICATION

(43) Date of publication:
**31.01.2024 Bulletin 2024/05**

(21) Application number: **23187074.2**

(22) Date of filing: **21.07.2023**

(51) International Patent Classification (IPC):
**H01M 10/42** *(2006.01)* **G01R 31/396** *(2019.01)*
**B60L 58/16** *(2019.01)*

(52) Cooperative Patent Classification (CPC):
**H01M 10/4207; B60L 58/16; G01R 31/396;**
H01M 2010/4271; H01M 2010/4278; H01M 2220/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.07.2022 CN 202210903909**

(71) Applicants:
- **ZHEJIANG ZEEKR INTELLIGENT TECHNOLOGY CO., LTD.**
  **315000 Ningbo Zhejiang (CN)**
- **Viridi E-Mobility Technology (Ningbo) Co., Ltd**
  **315000 Ningbo Zhejiang (CN)**
- **Zhejiang Geely Holding Group Co., Ltd.**
  **Hangzhou, Zhejiang 310000 (CN)**

(72) Inventors:
- **NIU, Shangbing**
  **Ningbo, 315000 (CN)**
- **ZHANG, Zhenglei**
  **Ningbo, 315000 (CN)**
- **GU, Bin**
  **Ningbo, 315000 (CN)**
- **ZHAO, Zhiwei**
  **Ningbo, 315000 (CN)**
- **SUN, Zhe**
  **Ningbo, 315000 (CN)**
- **DENG, Ziwei**
  **Ningbo, 315000 (CN)**
- **LIN, Chen**
  **Ningbo, 315000 (CN)**
- **ZHANG, Ruitian**
  **Ningbo, 315000 (CN)**
- **NIU, Yaqi**
  **Ningbo, 315000 (CN)**

(74) Representative: **Monteiro Alves, Inês**
**Alameda Dos Oceanos, Nº 41K-21**
**Parque das Nações**
**1990-207 Lisboa (PT)**

(54) **CONSISTENCY EVALUATION METHOD FOR VEHICLE BATTERY CELL, DEVICE, EQUIPMENT AND STORAGE**

(57) Disclosed are a consistency evaluation method for a vehicle battery cell, a device, an equipment, and a storage medium. The method includes: (S10), acquiring a vehicle operation data, and selecting an effective cell data in the vehicle operation data according to a preset effective data standard; (S20), processing the effective cell data according to a preset cell consistency index processing method to obtain an cell consistency index data; (S30), determining a total index deviation value of all battery cells in the current vehicle according to the cell consistency index data; and if the total index deviation value exceeds a preset deviation threshold, determining a consistency risk of the current vehicle.

```
acquiring the vehicle operation data, and selecting the effective cell data in the vehicle
operation data according to the preset effective data standard                              ⟍ S10

                                          ↓

processing the effective cell data according to the preset cell consistency index processing   ⟍ S20
method to obtain the cell consistency index data

                                          ↓

determining the total index deviation value of all battery cells in the current vehicle        ⟍ S30
according to the cell consistency index data; and in response to that the total index
deviation value exceeds the preset deviation threshold, determining the consistency risk of
the current vehicle
```

FIG. 2

EP 4 312 299 A2

**Description**

**TECHNICAL FIELD**

The present application relates to the technical field of new energy vehicles, and in particular to a consistency evaluation method for a vehicle battery cell, a device, an equipment and a storage medium.

**BACKGROUND**

New energy vehicles are usually equipped with a battery management system (BMS) to monitor and control the battery. A battery cell is the basic unit that makes up a battery pack, and the consistency of a battery cell refers to the convergence of important feature parameters of each battery cell. When the consistency of the battery cell in the vehicle battery pack is poor, the BMS will trigger a fault alarm, and the BMS will limit the performance of the vehicle, thereby resulting in a decline in the user's experience with the vehicle.

At present, when monitoring the consistency of vehicle battery cells, the usual solution is to detect the state of charge (SOC) and temperature of the battery cell at the vehicle end BMS. An alarm is triggered when the detected difference between the maximum and minimum values reaches the set threshold. This method is simple to implement, but it is extremely prone to produce false alarms and missed alarms, and the accuracy of consistency evaluation is low.

**SUMMARY**

The main purpose of the present application is to provide a consistency evaluation method for a vehicle battery cell, a device, an equipment and a storage medium, aiming to solve the problem of low accuracy of battery cell consistency evaluation.

In order to achieve the above purpose, the present application provides a consistency evaluation method for a vehicle battery cell, the method including:

acquiring a vehicle operation data, and selecting an effective cell data in the vehicle operation data according to a preset effective data standard;

processing the effective cell data according to a preset cell consistency index processing method to obtain an cell consistency index data;

determining a total index deviation value of all battery cells in the current vehicle according to the cell consistency index data; and

in response to that the total index deviation value exceeds a preset deviation threshold, determining a consistency risk of the current vehicle.

In an embodiment, before the selecting the effective cell data in the vehicle operation data according to the preset effective data standard, the method further includes:

detecting whether there is an abnormal data in the vehicle operation data; and

filtering the abnormal data to obtain an effective operation data in response to that the abnormal data exists.

In an embodiment, the selecting the effective cell data in the vehicle operation data according to the preset effective data standard includes:

obtaining a current data standard and a charging state standard in the effective data standard; and

selecting the effective operation data that meets the current data standard and the charging state standard as the effective cell data.

In an embodiment, the processing the effective cell data according to a preset cell consistency index processing method to obtain an cell consistency index data includes:

classifying the effective cell data to obtain a consistent initial data of each cell;

obtaining a cell consistency index processing method corresponding to the consistent initial data of each cell; and

processing the consistent initial data of each cell respectively according to the cell consistency index processing method to obtain a consistency index feature vector of each cell.

In an embodiment, the determining the total index deviation value of all battery cells in the current vehicle according to the cell consistency index data includes:

combining the consistency index feature vector of each cell into a cell index feature matrix;
determining a covariance matrix of the cell index feature matrix;
determining a Mahalanobis distance of each battery cell according to the cell index feature matrix and the covariance matrix; and
configuring the sum of the Mahalanobis distance of each battery cell as the total index deviation value.

In an embodiment, after the in response to that the total index deviation value exceeds the preset deviation threshold, determining the consistency risk of the current vehicle, the method further includes:

determining an average value of the Mahalanobis distance of each battery cell; and
selecting the battery cell whose average value of the Mahalanobis distance exceeds a preset distance threshold among the battery cells as a consistency risk cell.

In an embodiment, the consistency evaluation method for the vehicle battery cell further includes:

acquiring a deviation threshold correction parameter; and
correcting the deviation threshold according to the deviation threshold correction parameter.

In order to achieve the above purpose, the present application provides a consistency evaluation device for a vehicle battery cell, including:

an acquisition module, configured to acquire a vehicle operation data, and select an effective cell data in the vehicle operation data according to a preset effective data standard;
a processing module, configured to process the effective cell data according to a preset cell consistency index processing method to obtain a cell consistency index data; and
a determination module, configured to determine a total index deviation value of all battery cells in the current vehicle according to the cell consistency index data; and in response to that the total index deviation value exceeds a preset deviation threshold, determine a consistency risk of the current vehicle.

In order to achieve the above purpose, the present application provides an electronic equipment, including: a memory, a processor, and a consistency evaluation program for a vehicle battery cell stored on the memory and operable on the processor; the consistency evaluation program for the vehicle battery cell is configured to implement the steps of the consistency evaluation method for the vehicle battery cell mentioned above.

In order to achieve the above purpose, the present application provides a computer-readable storage medium; a consistency evaluation program for a vehicle battery cell is stored on the computer-readable storage medium, and when the consistency evaluation program for the vehicle battery cell is executed by a processor, the steps of the consistency evaluation method for the vehicle battery cell mentioned above are implemented.

The present application obtains the vehicle operation data, selects out the effective cell data in the vehicle operation data according to the preset effective data standard, processes the effective cell data according to the preset cell consistency index processing method to obtain the cell consistency index data, and determines the total index deviation value of all battery cells in the current vehicle according to the cell consistency index data. If the total index deviation value exceeds the preset deviation threshold, it is determined that the current vehicle has a consistency risk. The deviation value of the total index comprehensively reflects the condition of each consistency index of the battery cell, instead of the method of threshold judgment for a single consistency index, which makes the evaluation process more comprehensive and improves the accuracy of the evaluation results.

## BRIEF DESCRIPTION OF THE DRAWINGS

FIG. 1 is a schematic diagram of the consistency evaluation scenario of the vehicle battery cell according to the present application.
FIG. 2 is a schematic flowchart of the consistency evaluation method for the vehicle battery cell according to a first embodiment of the present application.
FIG. 3 is a schematic flowchart of the consistency evaluation method for the vehicle battery cell according to a second embodiment of the present application.

FIG. 4 is a schematic diagram of the consistency evaluation device of the vehicle battery cell according to the present application.

FIG. 5 is a schematic structural diagram of the electronic equipment in the hardware operating environment involved in the solution of the embodiment according to the present application.

The realization, functional features and advantages of the present application will be further described in conjunction with the embodiments and with reference to the accompanying drawings.

## DETAILED DESCRIPTION OF THE EMBODIMENTS

It should be understood that the specific embodiments described herein are only used to explain the present application, and are not intended to limit the present application.

Vehicle power battery packs are usually equipped with various sensors to monitor changes in battery pack voltage, current, temperature, battery state of charge and other indicators. In the power management system, many fault alarm strategies are often set for different indicators, such as over-temperature alarm, over-voltage/under-voltage alarm, alarm for large difference in single SOC, and so on. When certain alarms are triggered, for safety and other reasons, the BMS will limit some of the performance of the car, such as limiting the output power, limiting the available battery power, and so on. Among them, the poor consistency of the battery cells will lead to a large difference in the SOC of the battery cells, resulting in a decrease in the available capacity of the battery pack (barrel effect), or a large difference in the temperature of the battery cells during charging and discharging, thereby affecting battery performance. The consistency of battery cells is currently the focus of the industry and users.

At present, as for monitoring the battery cell consistency, the usual solution is to detect the SOC and temperature of the battery cell in the BMS of the vehicle. When the difference between the maximum SOC value and the minimum SOC value exceeds the threshold set at the factory, or the difference between the temperature maximum value and the temperature minimum value exceeds the threshold value set by the factory, an alarm will be triggered. However, in the case that the alarm is only triggered by the threshold value set at the factory, if the threshold value is set small, false alarms may occur; and if the threshold value is set large, missed alarms may occur. Moreover, adjusting the threshold value requires Over-the-Air Technology (OTA) upgrade or the vehicle enters the maintenance station to flash a new version of the software, the time period required to adjust the threshold is long and the operation is cumbersome. Most vehicle-end BMS only calculate the maximum, minimum, and average values of the battery cell indicators, and cannot evaluate and monitor the changes of each battery cell, and usually cannot evaluate the consistency of the internal resistance of the cell.

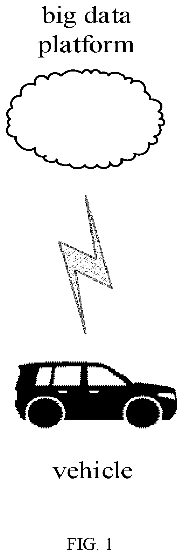

According to the GB/T 32960 requirements of the Ministry of Industry and Information Technology, new energy vehicles will upload the operation data to the big data platform established by the enterprise at a certain frequency. FIG. 1 is a schematic diagram of the consistency evaluation scenario of the vehicle battery cell in the present application. As shown in FIG. 1, the vehicle can communicate with the cloud big data platform. The data transmitted by the vehicle to the big data platform can include the data measured by various sensors at the vehicle end, which can reflect the operation of the vehicle more comprehensively. The big data platform can use the collected data to evaluate the consistency of vehicle battery cells.

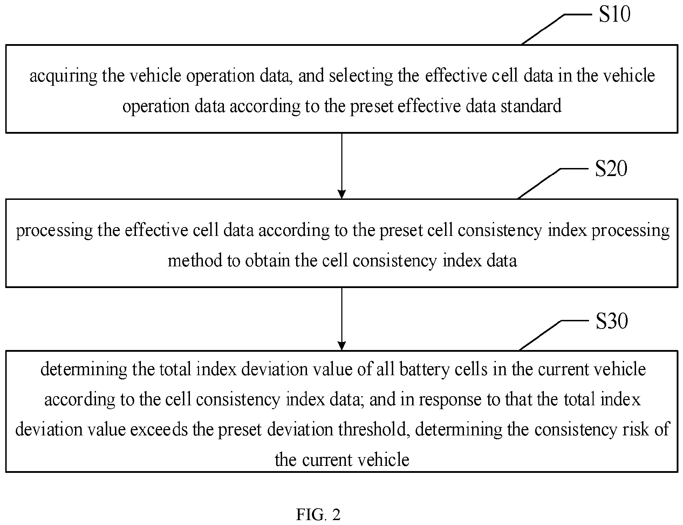

An embodiment of the present application provides a consistency evaluation method for a vehicle battery cell. Referring to FIG. 2, FIG. 2 is a schematic flowchart of the consistency evaluation method for the vehicle battery cell according to a first embodiment of the present application.

In this embodiment, the consistency evaluation method for the vehicle battery cell includes:

Step S10, acquiring the vehicle operation data, and selecting the effective cell data in the vehicle operation data according to the preset effective data standard.

It should be noted that this embodiment takes the big data platform shown in FIG. 1 as the execution subject. The big data platform obtains the vehicle operation data uploaded by the vehicle. According to the requirements of GB/T 32960, the big data platform can collect vehicle operation data of new energy vehicles on a daily basis. The vehicle operation data can include vehicle frame number, message sending time, total voltage of battery pack, total current, state of charge, insulation resistance, mileage, voltage of each battery cell, temperature measured by each temperature probe of the battery and motor bus voltage, etc.

The vehicle operation data contains various types of data representing the vehicle operation state. For battery cell consistency evaluation, effective cell data in the vehicle operation data can be selected out, and analysis and evaluation can be performed based on the effective cell data. The battery cell is the basic unit that makes up the vehicle battery pack. The cell data of the battery cell can be monitored through the temperature measuring probes and sensors installed at the battery cell, and the cell data that meets the preset effective data standard is regarded as the effective cell data.

As an example, before the step of selecting the effective cell data in the vehicle operation data according to the preset effective data standard, the method further includes:

Step A1, detecting whether there is an abnormal data in the vehicle operation data;

Step A2, filtering the abnormal data to obtain the effective operation data if the abnormal data exists.

There is a large amount of vehicle operation data in the big data platform, which may include abnormal data in abnormal situations. The vehicle operation data can be selected and cleaned to retain effective operation data in line with normal conditions.

Abnormal data can be divided into cell abnormal data and transmission abnormal data. The cell abnormal data is related to the condition of each battery cell in the vehicle power battery pack. The abnormal conditions of a battery cell can be that: the voltage of a single cell exceeds the effective value range, the temperature of the probe exceeds the effective value range, the voltages of all the cells are equal, and the temperatures of the probes are all equal and the amount of cells measured by the sensor are not the same as the actual amount of cells, etc. If the cell voltage exceeds the effective value range, it means that the voltage of the cell is too high or too low, which may affect the normal operation of the battery pack. If the temperature of the probe exceeds the effective value range, it means that the temperature of the cell is too high or too low, and the charging current may be too high and the electrolyte may decrease, or the probe may not be connected properly. Generally, there are differences between the cell voltage and cell temperature detected by the sensor, and there will not be a situation where they are all equal. If they are all equal, it means that there may be a problem with the sensor used to measure the cell voltage or cell temperature. The situation where the numbers are not the same is similar to this situation, and it may also be a problem with the sensor. The transmission of abnormal data is related to the data transmission between the vehicle and the big data platform. In some vehicles, the BMS has entered the dormant state, but the Telematics BOX (T-BOX) is still in the non-sleep state. At this time, the various sensors of the vehicle no longer collect and update data, but the T-BOX will still repeatedly send the data at the last moment before the BMS enters the dormant state. After filtering and removing abnormal data, effective operation data can be obtained.

The vehicle operation data contained in the big data platform is selected and cleaned to obtain effective operation data that meets the requirements of use, which can improve the efficiency of subsequent data processing.

As an example, the step of selecting effective cell data in the vehicle operation data according to the preset effective data standard may include:

> Step B1, obtaining the current data standard and charging state standard in the effective data standard;
> Step B2, selecting the effective operation data that meets the current data standard and the charging state standard as the effective cell data.

The effective operation data can be regarded as the original data before data selecting. The cell data in the effective operation data can be extracted first, and then different selecting operations are performed on the cell data according to different effective data standards to obtain effective cell data. The preset effective data standard can be adjusted according to the actual data analysis needs. The cell consistency indicators selected in this embodiment are cell SOC, cell temperature and cell internal resistance. Effective cell data is associated with cell consistency indicators, and the effective data standards corresponding to each cell consistency indicator can be different. The current data standard may include a current threshold interval. It should be noted that before obtaining the effective cell data corresponding to the cell consistency index, data processing can also be carried out. The cell data obtained by direct selecting is used as the intermediate quantity, and the data obtained by the final processing is the effective cell data.

The following is an example of different effective data standards: when the cell consistency index is the cell SOC, the current data standard can be $[-2,+2]A$, the charging state standard can be "not charged" or "charging completed" and last for more than 30 seconds, Then, according to the OCV (Open Circuit Voltage)-SOC curve provided by the battery supplier, the cell voltage Ui is converted into a cell SOCi, where i represents the cell number. When the cell consistency indicator is the cell temperature, the current data standard can be $[-2,+2]A$, and the charging state standard can be "not charged" or "charging completed" and last for more than 30 seconds. When the cell consistency index is the internal resistance of the cell, the current data standard can be the current difference between two adjacent frames of cell data $\Delta I = I_k - I_{k-1} \geq 0.2C$, where 1C current means the current required to fully charge the battery in one hour, for example, the nominal capacity of a battery is 100Ah, and the current required to fully charge this battery in 1 hour is 100A, then for this battery, $0.2C = 0.2 \times 100 = 20A$, Ik represents the current at time k, and Ik-1 represents the previous

$$R_i = \frac{U_k - U_{k-1}}{I_k - I_{k-1}}$$

time step at time k. Then according to , Uk represents the cell voltage at the k moment; Ik represents the cell current at the k moment, and the internal resistances Ri of all cells are calculated; and i represents the cell number.

Effective operation data conducts further data selecting, and eliminates the effective operation data that does not meet the effective data standards, which can improve the reference value of effective cell data, reduce the amount of data processing, and improve data processing efficiency.

Step S20, processing the effective cell data according to the preset cell consistency index processing method to obtain the cell consistency index data.

The cell consistency index data characterizes the consistency performance of each cell in terms of consistency indicators. The median or average can be used as the center point of the effective cell data to calculate the distance between each effective cell data and the center point as the cell consistency index data.

As an example, processing the effective cell data according to the preset cell consistency index processing method to obtain the cell consistency index data may include:

Step C1, classifying the effective cell data to obtain the consistent initial data of each cell;

Step C2, obtaining the cell consistency index processing method corresponding to the consistent initial data of each cell; and respectively processing the consistent initial data of each cell according to the cell consistency index processing method to obtain the consistency index feature vector of each cell.

When selecting the effective cell data, there may be situations where the effective data standards are the same, such as the above-mentioned cell SOC index and cell temperature index. Before data processing is performed to obtain the final effective cell data, the intermediate data obtained by the two are identical. At this time, the intermediate quantity data can be classified according to the cell consistency index, and the consistent initial data of the cell SOC index and the consistent initial data of the cell temperature index are obtained. The consistent initial data of cell of each category can correspond to different cell consistency index processing methods, and finally obtain the consistency index feature vector of each cell. The consistency index feature vector of the cell can be used as the cell consistency index data to represent the consistency deviation of the cell index.

When the cell consistency index is the cell SOC, the corresponding cell consistency index processing method flow can be as follows: the cell SOCmedian in each frame of the consistent initial data of the cell is calculated, and then each cell SOCi is used to subtract the SOCmedian of each cell in this frame to obtain the deviation between the SOC of each cell in this frame of data and the SOCmedian, that is, $diffSOC_i = SOC_i - SOC_{median}$ ; then the average deviation of each cell SOC is calculated to obtain the feature vector of the cell SOC with the size nx1, where n is the number of battery cells in the battery pack. The feature vector is the cell SOC consistency index data.

$$feature_{SOC} = \left[\overline{diffSOC_1}, \overline{diffSOC_2}, \ldots, \overline{diffSOC_i}\right], \quad i \in [1, \ n]$$

$$\overline{diffSOC_i} = \frac{\sum diffSOC_{1,m}}{m},$$

m is the number of data frames that meet the effective data standard; featureSOC represents the feature vector of the cell SOC.

When the cell consistency index is the cell temperature, the corresponding cell consistency index processing method flow can be as follows: calculating the median temperature Tmedian of the probes in the consistent initial data of each frame of cell, and then using each cell Ti to subtract the median temperature Tmedian of the probes in this frame of data to obtain the deviation between the temperature of each probe in this frame of data and the median, that is $diffT_i = T_i - T_{median}$; calculating the average deviation of the temperature of each cell in the battery to obtain the cell temperature feature vector with the size of nx1, where n is the number of battery cells in the battery pack. The feature vector is the cell temperature consistency index data.

$$feature_{temp} = \left[\overline{diffT_1}, \overline{diffT_2}, \ldots, \overline{diffT_i}\right], \quad i \in [1, \ n]$$

$$\overline{diffT_i} = \frac{\sum diffT_{1,m}}{m},$$

m is the number of data frames that meet the effective data standard.

When the cell consistency index is the cell internal resistance, the corresponding cell consistency index processing method flow can be as follows: calculating the median Rmedian of the cell internal resistance in each frame of cell consistency initial data, and then using each cell Ri to subtract the median Rmedian of the internal resistance of each cell in this frame of data to obtain the deviation between the internal resistance of each cell in this frame of data and the median, that is $diffR_i = R_i - R_{median}$, calculating the average deviation of the internal resistance of each cell of the battery to obtain the cell internal resistance feature vector with the size of nx1, where n is the number of battery cells in the battery pack. The feature vector is the cell internal resistance consistency index data.

$$ feature_R = \left[ \overline{\overline{diffR_1}}, \overline{\overline{diffR_2}}, \ldots\ldots, \overline{\overline{diffR_i}} \right], \quad i \in \left[ 1, \ n \right] $$

$$ \overline{\overline{diffR_i}} = \frac{\sum diffR_{i,m}}{m}, $$

m is the number of data frames that meet the effective data standard.

Using feature vectors to represent cell consistency index data facilitates subsequent integration of cell consistency index data and enhances the comprehensiveness of battery cell consistency evaluation.

Step S30, determining the total index deviation value of all battery cells in the current vehicle according to the cell consistency index data; and in response to that the total index deviation value exceeds the preset deviation threshold, determining the consistency risk of the current vehicle.

The total index deviation value represents the comprehensive deviation value of the consistency index of each cell. In this embodiment, the cell SOC index, the cell temperature index and the cell internal resistance index are used to comprehensively evaluate the consistency deviation performance of the cell. The preset deviation threshold can be adjusted through the big data platform. When it is judged that the deviation threshold needs to be adjusted according to the actual situation, the big data platform can obtain the deviation threshold correction parameter, and correct the deviation threshold according to the deviation threshold correction parameter. In general, the method of setting the deviation threshold between the maximum value and the minimum value of the cell index data for the vehicle at the factory requires writing the deviation threshold data into hardware facilities such as chips inside the vehicle, and the threshold adjustment operation is cumbersome and time-consuming. However, in this embodiment, the deviation threshold is corrected through the big data platform, which is easy to operate.

As an example, the step of determining the total index deviation value of all battery cells in the current vehicle according to the consistency index deviation value of each cell may include:

Step D1, combining the consistency feature vectors of each cell into a cell index feature matrix, and determining the covariance matrix of the cell index feature matrix;

Step D2, determining the Mahalanobis distance of each battery cell according to the cell index feature matrix and the covariance matrix, and configuring the sum of the Mahalanobis distances of each battery cell as the total index deviation value.

The cell SOC feature vector, the cell temperature feature vector, and the cell internal resistance feature vector form a multi-parameter feature matrix $X = \left[ feature_{SOC}{}^T, \ feature_{temp}{}^T, \ feature_R{}^T \right]$ ; alculating the average ui of the three indicators and forming the mean vector $\mu = [\mu_1, \mu_2, \mu_2, \mu_3]$, to calculate the covariance matrix $\Sigma$ of the matrix X:

$$ \Sigma = \begin{vmatrix} \sigma_{11} & \sigma_{12} & \sigma_{13} \\ \sigma_{21} & \sigma_{22} & \sigma_{23} \\ \sigma_{31} & \sigma_{32} & \sigma_{33} \end{vmatrix}, \quad \sigma_{ij} = E(X_i - \mu_i) \bullet E(X_j - \mu_j), \quad i, \ j = 1,2,3 $$

Calculating the Mahalanobis distance D (Xi) of cell i according to the formula

$$ D(X_i) = \sqrt{(X_i - \mu')^T \Sigma^{-1} (X_i - \mu')} \; ; $$

Calculating the sum $sum = \sum_i^n D(X_i)$ of all cell Mahalanobis distances as the total index deviation value. If the total index deviation value sum exceeds the threshold value, it means that the current vehicle corresponding to the cell effective data has a consistency risk. The big data platform can send consistency risk warning information to the current vehicle, reminding users to perform vehicle maintenance before the vehicle BMS restricts vehicle functions, so as to avoid affecting the car experience due to the alarm of poor battery consistency.

As an example, after the step of determining that the current vehicle has a consistency risk if the total index deviation exceeds a preset deviation threshold, the method may further include:

Step E1, determining the average Mahalanobis distance of each battery cell;
Step E2, selecting the battery cells whose average Mahalanobis distance exceeds a preset distance threshold among the battery cells as consistency risk cells.

Calculating the average $\overline{D}(X_i)$ of the Mahalanobis distance D (Xi) of all battery cells in the current vehicle, and further calculating the standard deviation $\sigma$. The preset distance threshold can be $3\sigma$, and the cells with a difference of more than 3 from the average $\overline{D}(X_i)$ of Mahalanobis distance of all cells are selected out as cells with poor consistency and consistency risk. The big data platform can also send the consistency risk warning information of the battery cell to the current vehicle, which is convenient for quickly finding the problem cell during vehicle maintenance.

In this embodiment, the vehicle operation data is obtained. The effective cell data in the vehicle operation data are selected out according to the preset effective data standard, and the effective cell data is processed according to the preset cell consistency index processing method to obtain cell consistency index data. The total index deviation value of all battery cells in the current vehicle is determined according to the cell consistency index data. If the total index deviation value exceeds the preset deviation threshold, it is determined that the current vehicle has a consistency risk. The total index deviation value comprehensively reflects the condition of each consistency index of the battery cell, instead of the threshold judgment method of a single consistency index, which makes the evaluation process more comprehensive and improves the accuracy of the evaluation results.

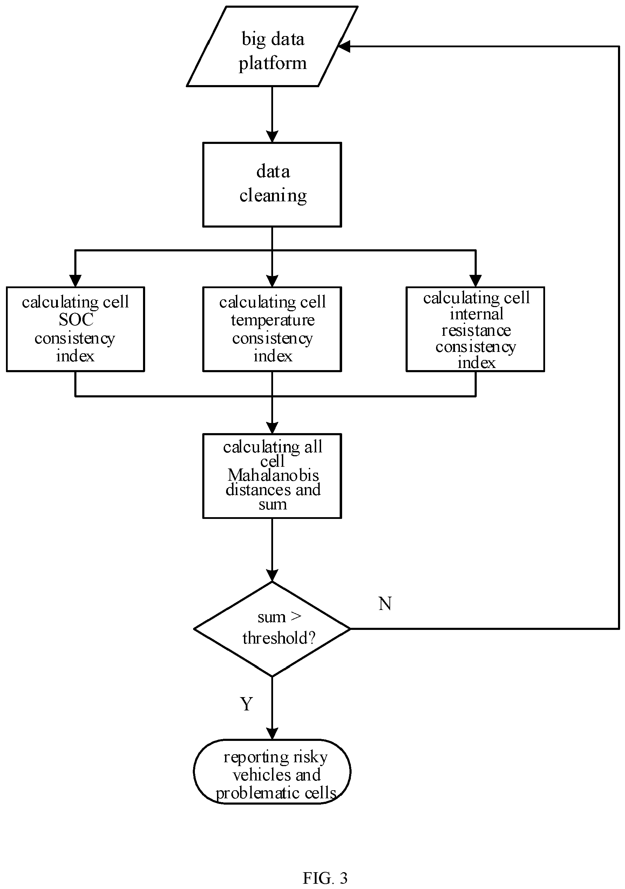

In the second embodiment of the consistency evaluation method for the vehicle battery cell of the present application, as shown in FIG. 3, the big data platform collects vehicle operation data, performs data selecting and cleaning on the vehicle operation data, removes abnormal data, and uses the filtered data to calculate the cell SOC consistency index, the cell temperature consistency index and the cell internal resistance consistency index respectively. And the big data platform uses the feature vector to represent the cell feature index, and forms the feature vector into a multi-parameter feature matrix. The Mahalanobis distance and the sum of the Mahalanobis distances of each cell are calculated according to the Mahalanobis distance calculation formula. It is determined that whether the sum of the Mahalanobis distances is greater than the preset deviation threshold. If the sum of the Mahalanobis distances is greater than the preset deviation threshold, it means that the current vehicle corresponding to the current vehicle operation data has a consistency risk and is a risk vehicle. In the risky vehicle, the cell whose Mahalanobis distance is more than 3 times the standard deviation of all cells is a problem cell. If the sum of the Mahalanobis distances is less than or equal to the preset deviation threshold, it means that the current vehicle has no consistency risk, and the big data platform can continue to evaluate the battery cells and consistency of other vehicles.

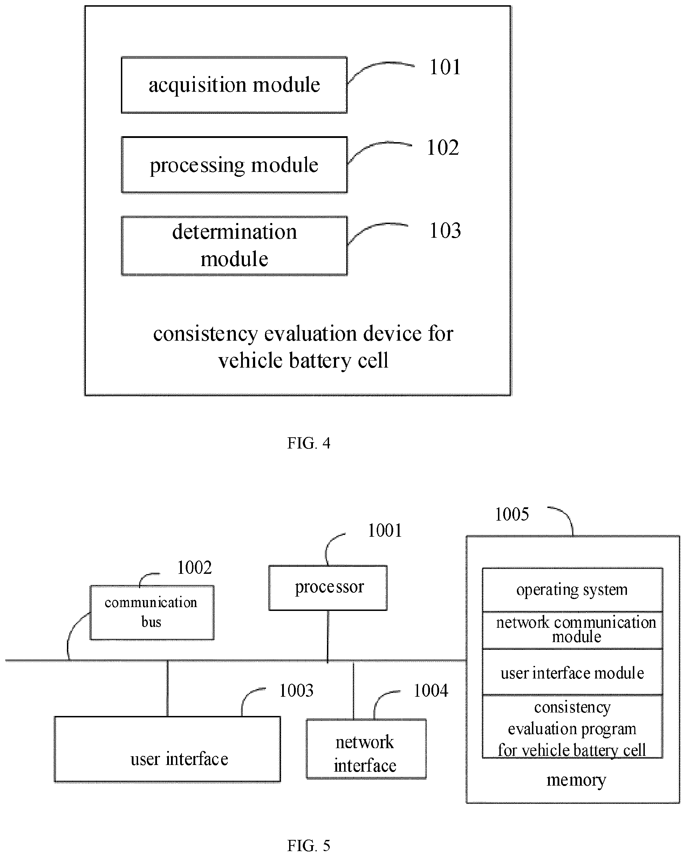

The embodiment of the present application also provides a consistency evaluation device for a vehicle battery cell, as shown in FIG. 4, the consistency evaluation device for the vehicle battery cell includes:

the acquisition module 101, configured to acquire the vehicle operation data, and select the effective cell data in the vehicle operation data according to the preset effective data standard;
the processing module 102, configured to process the effective cell data according to the preset cell consistency index processing method to obtain the cell consistency index data; and
the determination module 103, configured to determine the total index deviation value of all battery cells in the current vehicle according to the cell consistency index data; and in response to that the total index deviation value exceeds the preset deviation threshold, determine the consistency risk of the current vehicle.

In an embodiment, the acquisition module 101 is also configured for:

detecting whether there is an abnormal data in the vehicle operation data;
if the abnormal data exists, the abnormal data is filtered to obtain an effective operation data.

In an embodiment, the acquisition module 101 is also configured for:

obtaining the current data standard and the charging state standard in the effective data standard;
selecting the effective operation data that meets the current data standard and the charging state standard as the effective cell data.

In an embodiment, the processing module 102 is also configured for:

classifying the effective cell data to obtain the consistent initial data of each cell;
obtaining the cell consistency index processing method corresponding to the cell consistency initial data, and respectively processing the cell consistency initial data according to the cell consistency index processing method to obtain the consistency index feature vector of each cell.

In an embodiment, the determination module 103 is also configured for:

combining the consistency feature vectors of each cell into a cell index feature matrix, and determining the covariance matrix of the cell index feature matrix;
determining the Mahalanobis distance of each battery cell according to the cell index feature matrix and the covariance matrix, and configuring the sum of the Mahalanobis distances of each battery cell as the total index deviation value.

In an embodiment, the consistency evaluation device of vehicle battery cell also includes a selection module for:

determining the standard deviation of the Mahalanobis distance of each battery cell;
selecting the battery cells whose standard deviation from the Mahalanobis distance exceeds a preset distance threshold among the battery cells as consistency risk cells.

In an embodiment, the consistency evaluation device of vehicle battery cell also includes a correction module for: acquiring a deviation threshold correction parameter, and correcting the deviation threshold according to the deviation threshold correction parameter.
FIG. 5 is a schematic structural diagram of an electronic equipment in a hardware operating environment involved in the solution of the embodiment of the present application.
As shown in FIG. 5, the electronic equipment may include: a processor 1001, such as a central processing unit (CPU), a communication bus 1002, a user interface 1003, a network interface 1004, and a memory 1005. The communication bus 1002 is used to realize connection and communication between these components. The user interface 1003 may include a display screen, an input unit such as a keyboard, and the optional user interface 1003 may also include a standard wired interface and a wireless interface. The network interface 1004 may include a standard wired interface and a wireless interface (such as a wireless fidelity (WI-FI) interface). The memory 1005 may be a high-speed random access memory (RAM), or a stable non-volatile memory (NVM), such as a disk memory. The memory 1005 may also be a storage device independent of the aforementioned processor 1001.
Those skilled in the art can understand that the structure shown in FIG. 5 does not constitute a limitation on the electronic equipment, and may include more or less components than shown in the figure, or combine some components, or arrange different components.
As shown in FIG. 5, the memory 1005 as a storage medium may include an operating system, a network communication module, a user interface module, and a consistency evaluation program of a vehicle battery cell.
In the electronic equipment shown in FIG. 5, the network interface 1004 is mainly used for data communication with other devices; the user interface 1003 is mainly used for data interaction with the user; the processor 1001 and the memory 1005 in the electronic equipment of the present application can be set in the electronic equipment; the electronic equipment calls the consistency evaluation program of the vehicle battery cell stored in the memory 1005 through the processor 1001, and executes the consistency evaluation method for the vehicle battery cell provided in the embodiment of the present application.
The embodiment of the present application also provides a computer-readable storage medium. The computer-readable storage medium stores a consistency evaluation program of a vehicle battery cell, and when the consistency evaluation program of the vehicle battery cell is executed by a processor, the above steps of the consistency evaluation method for the vehicle battery cell described in the article are realized.
It should be noted that, as used herein, the term "comprise", "include" or any other variation thereof is intended to cover a non-exclusive inclusion such that a process, method, article or system comprising a set of elements includes not only those elements, it also includes other elements not expressly listed, or elements inherent in the process, method, article, or system. Without further limitations, an element defined by the phrase "comprising a ..." does not preclude the presence of additional identical elements in the process, method, article, or system comprising that element.
The serial numbers of the above embodiments of the present application are for description only, and do not represent the advantages and disadvantages of the embodiments.

Through the description of the above embodiments, those skilled in the art can clearly understand that the methods of the above embodiments can be implemented by means of software plus a necessary general-purpose hardware platform, and of course also by hardware, but in many cases the former is a better implementation. Based on such an understanding, the technical solution of the present application can be embodied in the form of a software product in essence or the part that contributes to the related art, and the computer software product is stored in a storage medium as described above (such as ROM/RAM , magnetic disk, optical disk), including several instructions to enable a terminal device (which may be a mobile phone, computer, server, or network device, etc.) to execute the methods described in various embodiments of the present application.

The above are only some embodiments of the present application, and are not intended to limit the patent scope of the present application. Any equivalent structure or equivalent process transformation made by using the contents of the specification and drawings of the present application, or directly or indirectly used in other related technical fields, is also included in the scope of the present application.

**Claims**

1.  A consistency evaluation method for a vehicle battery cell **characterized by** comprising:

    (S10), acquiring a vehicle operation data, and selecting an effective cell data in the vehicle operation data according to a preset effective data standard;
    (S20), processing the effective cell data according to a preset cell consistency index processing method to obtain an cell consistency index data; and
    (S30), determining a total index deviation value of all battery cells in the current vehicle according to the cell consistency index data; and in response to that the total index deviation value exceeds a preset deviation threshold, determining a consistency risk of the current vehicle.

2.  The consistency evaluation method for the vehicle battery cell according to claim 1, wherein before the selecting the effective cell data in the vehicle operation data according to the preset effective data standard, the method further comprises:

    detecting whether there is an abnormal data in the vehicle operation data; and
    filtering the abnormal data to obtain an effective operation data in response to that the abnormal data exists.

3.  The consistency evaluation method for the vehicle battery cell according to claim 2, wherein the selecting the effective cell data in the vehicle operation data according to the preset effective data standard comprises:

    obtaining a current data standard and a charging state standard in the effective data standard; and
    selecting the effective operation data that meets the current data standard and the charging state standard as the effective cell data.

4.  The consistency evaluation method for the vehicle battery cell according to claim 1, wherein the processing the effective cell data according to a preset cell consistency index processing method to obtain the cell consistency index data comprises:

    classifying the effective cell data to obtain a consistent initial data of each cell;
    obtaining a cell consistency index processing method corresponding to the consistent initial data of each cell; and
    processing the consistent initial data of each cell respectively according to the cell consistency index processing method to obtain a consistency index feature vector of each cell.

5.  The consistency evaluation method for the vehicle battery cell according to claim 4, wherein the determining the total index deviation value of all battery cells in the current vehicle according to the cell consistency index data comprises:

    combining the consistency index feature vector of each cell into a cell index feature matrix;
    determining a covariance matrix of the cell index feature matrix;
    determining a Mahalanobis distance of each battery cell according to the cell index feature matrix and the covariance matrix; and

configuring a sum of the Mahalanobis distance of each battery cell as the total index deviation value.

6. The consistency evaluation method for the vehicle battery cell according to claim 5, wherein after the in response to that the total index deviation value exceeds the preset deviation threshold, determining the consistency risk of the current vehicle, the method further comprises:

determining an average value of the Mahalanobis distance of each battery cell; and
selecting the battery cell whose average value of the Mahalanobis distance exceeds a preset distance threshold among the battery cells as a consistency risk cell.

7. The consistency evaluation method for the vehicle battery cell according to any one of claims 1 to 6, further comprising:

acquiring a deviation threshold correction parameter; and
correcting the deviation threshold according to the deviation threshold correction parameter.

8. A consistency evaluation device for a vehicle battery cell **characterized by** comprising:

an acquisition module (101), configured to acquire a vehicle operation data, and select an effective cell data in the vehicle operation data according to a preset effective data standard;
a processing module (102), configured to process the effective cell data according to a preset cell consistency index processing method to obtain a cell consistency index data; and
a determination module (103), configured to determine a total index deviation value of all battery cells in the current vehicle according to the cell consistency index data; and in response to that the total index deviation value exceeds a preset deviation threshold, determine a consistency risk of the current vehicle.

9. An electronic equipment **characterized by** comprising:

a memory (1005);
a processor (1001); and
a consistency evaluation program for a vehicle battery cell stored on the memory (1005) and operable on the processor (1001),
wherein the consistency evaluation program for the vehicle battery cell is configured to implement the consistency evaluation method for the vehicle battery cell according to any one of claims 1 to 7.

10. A computer-readable storage medium **characterized by** the fact that a consistency evaluation program for a vehicle battery cell is stored on the computer-readable storage medium, and when the consistency evaluation program for the vehicle battery cell is executed by a processor (1001), the consistency evaluation method for the vehicle battery cell according to any one of claims 1 to 7 is implemented.

big data
platform

vehicle

FIG. 1

S10

acquiring the vehicle operation data, and selecting the effective cell data in the vehicle operation data according to the preset effective data standard

S20

processing the effective cell data according to the preset cell consistency index processing method to obtain the cell consistency index data

S30

determining the total index deviation value of all battery cells in the current vehicle according to the cell consistency index data; and in response to that the total index deviation value exceeds the preset deviation threshold, determining the consistency risk of the current vehicle

FIG. 2

big data
platform

data
cleaning

calculating cell
SOC
consistency
index

calculating cell
temperature
consistency
index

calculating cell
internal
resistance
consistency
index

calculating all
cell
Mahalanobis
distances and
sum

sum >
threshold?

N

Y

reporting risky
vehicles and
problematic cells

FIG. 3

acquisition module ⟶ 101

processing module ⟶ 102

determination module ⟶ 103

consistency evaluation device for vehicle battery cell

FIG. 4

1005

1001

1002

communication bus

processor

operating system

network communication module

user interface module

consistency evaluation program for vehicle battery cell

1003

1004

user interface

network interface

memory

FIG. 5